(19) **Europäisches Patentamt European Patent Office Office européen des brevets**

(11) **EP 4 521 131 A1**

(12) **EUROPEAN PATENT APPLICATION**

(43) Date of publication:
**12.03.2025 Bulletin 2025/11**

(21) Application number: **24176878.7**

(22) Date of filing: **20.05.2024**

(51) International Patent Classification (IPC):
*G01R 31/396* (2019.01)

(52) Cooperative Patent Classification (CPC):
**G01R 31/396**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.09.2023 JP 2023145273**

(71) Applicant: **Kabushiki Kaisha Toshiba**
**Tokyo 105-0023 (JP)**

(72) Inventors:
- **SUGIYAMA, Nobukatsu**
  **Tokyo, 105-0023 (JP)**
- **FUJITA, Yumi**
  **Tokyo, 105-0023 (JP)**
- **MORITA, Tomokazu**
  **Tokyo, 105-0023 (JP)**

(74) Representative: **Marks & Clerk LLP**
**15 Fetter Lane**
**London EC4A 1BW (GB)**

(54) **INFORMATION PROCESSING DEVICE, INFORMATION PROCESSING METHOD, COMPUTER-READABLE MEDIUM, AND INFORMATION PROCESSING SYSTEM**

(57) According to an arrangement, an information processing device (10) includes a memory (16) and one or more processors (18) coupled to the memory. The one or more processors (18) are configured to calculate a ratio between an assembled battery capacity of an assembled battery (20) in which a plurality of battery cells (22) are serially connected and a cell capacity of a specific battery cell in the plurality of battery cells (22) included in the assembled battery (20), as an index indicating a degree of collapse of a cell balance of the assembled battery (20).

FIG.1

EP 4 521 131 A1

**Description**

FIELD

The present disclosure relates to an information processing device, an information processing method, a computer-readable medium, and an information processing system.

BACKGROUND

There has been proposed a method of estimating a degree of collapse of a cell balance between a plurality of battery cells included in an assembled battery in which the plurality of battery cells are serially connected. For example, there is disclosed a method of using a charging capacity at a certain cell voltage or an SOC (state of charge) difference between cell voltages as an index indicating a degree of collapse of a cell balance.

However, the conventional index is expressed to include SOH (state of health) of a battery cell, and thus cannot appropriately express the state of the cell balance. For this reason, the conventional technology does not provide an index that appropriately expresses the degree of collapse of the cell balance of the assembled battery.

BRIEF DESCRIPTION OF THE DRAWINGS

Fig. 1 is a schematic diagram illustrating an information processing system according to an arrangement;
Fig. 2A is a diagram illustrating a state of an assembled battery in an initial state;
Fig. 2B is a diagram illustrating a state of the assembled battery in a deteriorated state;
Fig. 3 is a flowchart illustrating a flow of information processing that is executed by a processor; and
Fig. 4 is a hardware configuration diagram.

DETAILED DESCRIPTION

In general, according to an arrangement, an information processing device includes a memory and one or more processors coupled to the memory. The one or more processors are configured to calculate a ratio between an assembled battery capacity of an assembled battery in which a plurality of battery cells are serially connected and a cell capacity of a specific battery cell in the plurality of battery cells included in the assembled battery, as an index indicating a degree of collapse of a cell balance of the assembled battery.

Exemplary arrangements of an information processing device, an information processing method, a computer-readable medium, and an information processing system will be explained below in detail with reference to the accompanying drawings. The present invention is not limited to the following arrangements.

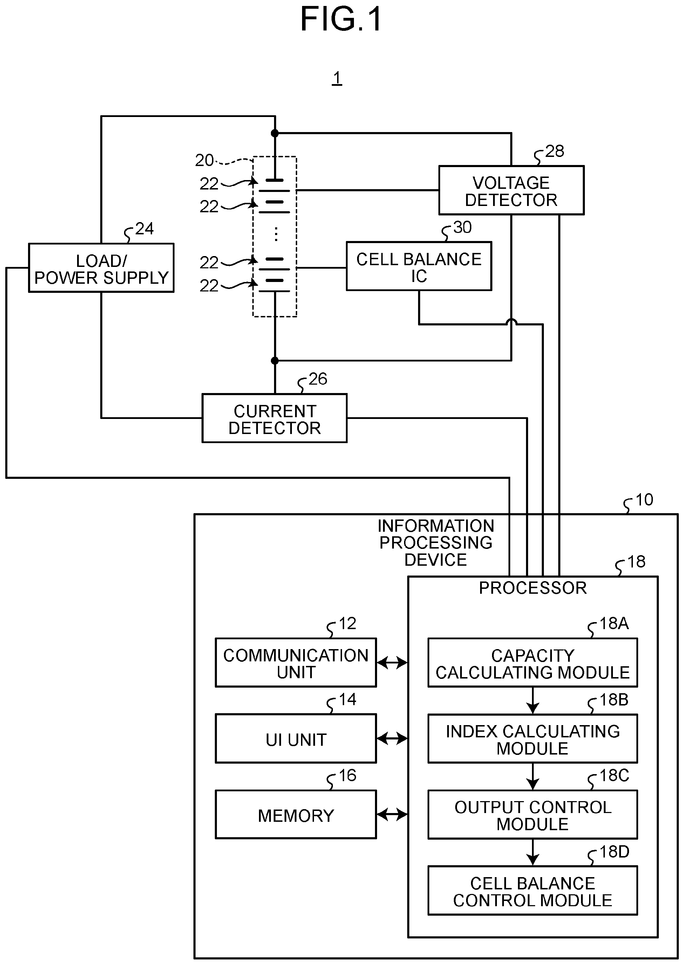

Fig. 1 is a schematic diagram illustrating an example of an information processing system 1 according to the present arrangement.

The information processing system 1 includes an information processing device 10, an assembled battery 20, a load/power supply 24, a current detector 26, a voltage detector 28, and a cell balance IC (integrated circuit) 30.

The assembled battery 20 is a battery in which a plurality of battery cells 22 are serially connected. The battery cell 22 is a secondary battery such as a lithium-ion battery. The battery cell 22 may be referred to as a single battery.

The number of the serially-connected battery cells 22 included in the assembled battery 20 may be two or more. For example, the number of the serially-connected battery cells 22 included in the assembled battery 20 may be around several hundred. Note that the assembled battery 20 may have a configuration that cell blocks each including the plurality of battery cells 22 connected in parallel are serially connected. In this case, each of the serially-connected cell blocks corresponds to a battery cell according to the present arrangement.

The assembled battery 20 is mounted on a battery equipped apparatus, for example. A battery equipped apparatus includes a large-sized storage battery for electric power system, a smartphone, a vehicle, a stationary power supply device, a robot, a drone, and the like. A vehicle includes a railway vehicle, an electric bus, an electric vehicle, and the like.

The load/power supply 24 is connected to the assembled battery 20, and acts as a load consuming electric power of the assembled battery 20 and a power supply supplying electric power to the assembled battery 20.

The current detector 26 detects an electric current flowing in the assembled battery 20. The current detector 26 measures an electric current flowing through the serially-connected battery cells 22 included in the assembled battery 20 at one place to detect an electric current flowing through the entire of the assembled battery 20 and an electric current flowing through each of the plurality of battery cells 22.

The voltage detector 28 measures a voltage between a positive terminal and a negative terminal of the assembled battery 20 and a voltage between a positive terminal and a negative terminal of each of the battery cells 22 included in the assembled battery 20.

The cell balance IC 30 is an IC that performs the control of aligning voltages of the plurality of battery cells 22 included in the assembled battery 20 to the same voltage and equalizing variation in the cell capacity between the battery cells 22. The cell balance IC 30 may employ a well-known cell balance IC. The cell balance IC 30 may be any of a passive IC and an active IC.

The information processing device 10 executes a calculation process etc. of an index indicating a degree of collapse of a cell balance of the assembled battery 20. The information processing device 10 is electrically connected to the load/power supply 24, the current detector 26, the voltage detector 28, and the cell balance IC 30.

The information processing device 10 includes a communication unit 12, a UI (user interface) unit 14, a memory 16, and a processor 18. The communication unit 12, the UI unit 14, and the memory 16 are connected to the processor 18 by a bus etc. to be able to communicate with each other.

The communication unit 12 communicates with an external information processing device via the network etc. The UI unit 14 has an input function receiving an operation input by a user and an output function outputting various information. The input function is an input device such as a keyboard. The output function is a display displaying various information, a speaker outputting a voice, and the like. The memory 16 stores therein various information.

The processor 18 is an arithmetic unit that executes information processing. The processor 18 includes a capacity calculating module 18A, an index calculating module 18B, an output control module 18C, and a cell balance control module 18D.

At least one of the capacity calculating module 18A, the index calculating module 18B, the output control module 18C, and the cell balance control module 18D is realized by one or more processors, for example. For example, each module described above may be realized by causing a processor such as CPU to execute a program, that is, by software. Each module described above may realize by a processor such as a dedicated IC (integrated circuit), that is, by hardware. Each module described above may be realized by using software and hardware together. When using a plurality of processors, each processor may realize one of the modules, or may realize two or more of the modules.

Note that the processor 18 may have a configuration that includes at least the capacity calculating module 18A and the index calculating module 18B, or may have a configuration that does not include at least one of the output control module 18C and the cell balance control module 18D.

Moreover, there may be employed a configuration that at least one of "at least one of the functional modules included in the processor 18" and "at least part of each type of information stored in the memory 16" is mounted on an external information processing device etc. connected to the information processing device 10 to be able to communicate with each other.

Note that the processor 18 may be realized by processing circuits such as "one or more CPUs, microprocessors, GPUs (graphics processing unit), ASICs (application specific integrated circuit), and FPGAs (field-programmable gate array)", or electronic circuits including these circuits etc. Moreover, the processor 18 may be realized by an information processing device such as a computer, a computer system in which a plurality of computers or servers are configured to communicate with each other via the network, a PC cluster in which a plurality of computers execute information processing in collaboration, or the like.

The capacity calculating module 18A calculates the assembled battery capacity of the assembled battery 20 and the cell capacities of the battery cells 22 included in the assembled battery 20.

The assembled battery capacity indicates the estimated full charge capacity of the assembled battery 20. The cell capacity indicates the estimated full charge capacity of the battery cell 22.

By using the detection result by the current detector 26 and the detection result by the voltage detector 28, the capacity calculating module 18A may calculate the cell capacity of each of the plurality of battery cells 22 included in the assembled battery 20 and the assembled battery capacity of the assembled battery 20 in a well-known method.

Specifically, for example, based on the voltage and current of the assembled battery 20, the voltage and current of at least some of the battery cells 22 included in the assembled battery 20, and an internal state calculated by regression calculation from a relationship between the charge amount and voltage of active material of the battery cells 22, the capacity calculating module 18A calculates the cell capacities and the assembled battery capacity.

In detail, the capacity calculating module 18A records, when charging or discharging the assembled battery 20, a current of each of the assembled battery 20 and the battery cells 22 detected by the current detector 26 and a voltage of each of the assembled battery 20 and the battery cells 22 detected by the voltage detector 28 in the memory 16 as a charging history. The capacity calculating module 18A updates the charging history by repeating the record every predetermined time. The predetermined time is not limited, but the time is preferably to be about 0.1 seconds to 1 second, for example.

The capacity calculating module 18A calculates an internal state of the battery cell 22 by the regression calculation from the charging history in the well-known method etc. disclosed in Japanese Laid-open Patent Publication No. 2012-251806 etc.

The internal state of the battery cell 22 is expressed by a positive electrode capacity of the battery cell 22, a negative electrode capacity of the battery cell 22, a positive electrode charge amount of the battery cell 22 at a certain time point, a negative electrode charge amount of the battery cell 22 at a certain time point, an internal resistance of the battery cell 22, or the like. The positive electrode capacity of the battery cell 22 is an amount of active material constituting the positive electrode of the battery cell 22. The negative electrode capacity of the battery cell 22 is an amount of active material constituting the negative electrode of the battery cell 22.

By using a function of calculating a battery voltage from the active material amount and the internal resistance and a function indicating a relationship between the charge amount and the electric potential, the capacity calculating module 18A calculates the internal state by performing the regression calculation from the charging history.

Assuming that the battery cell 22 is a secondary battery in which each of the positive electrode and the negative electrode of the battery cell is made of one active material, the voltage of the battery cell 22 is expressed by Expression (1) when the voltage is represented with an overvoltage by the OCP (open circuit potential) of the positive electrode, the OCP of the negative electrode, and the internal resistance.

$$\hat{V}(Q,\theta) = f_c\left(\frac{Q}{M_c} + q_{0c}\right) - f_a\left(\frac{Q}{M_a} + q_{0a}\right) + RI \qquad \cdots (1)$$

$\hat{V}(Q,\theta)$ : Voltage of battery cell

$Q$ : Charge amount of battery cell

$\theta$ : Internal state

$f_c$ : Function indicating relationship between charge amount and electric potential of positive electrode

$f_a$ : Function indicating relationship between charge amount and electric potential of negative electrode

$M_c$ : Positive electrode capacity of battery cell

$M_a$ : Negative electrode capacity of battery cell

$q_{0c}$ : Positive electrode charge amount of battery cell at certain time point

$q_{0a}$ : Negative electrode charge amount of battery cell at certain time point

$R$ : Internal resistance of battery cell

$I$ : Current value of battery cell

The internal state $\theta$ is expressed by a vector, and is expressed by Expression (2).

$$\theta = [M_c, M_a, q_{0c}, q_{0a}, R]^T \qquad \cdots (2)$$

The capacity calculating module 18A acquires a current value of the battery cell 22 at a certain time point from the charging history. Moreover, the capacity calculating module 18A integrates the current value over time by using the charging history to calculate the positive electrode charge amount and the negative electrode charge amount at a certain time point. Moreover, the function indicating a relationship between the charge amount and the electric potential of the positive electrode and the function indicating a relationship between the charge amount and the electric potential of the negative electrode may be previously stored in the memory 16.

Then, the capacity calculating module 18A performs regression calculation, in such a manner that a residual dross between a voltage value of the battery cell 22 associated with a predetermined time in the charging history and a voltage value calculated by Expression (1) becomes small, to calculate the internal state $\theta$. The regression calculation may employ the calculation method disclosed in Japanese Laid-open Patent Publication No. 2018-77259, Japanese Laid-open Patent Publication No. 2015-111086, or Japanese Laid-open Patent Publication No. 2012-251806.

Moreover, the internal state $\theta$ may include a positive electrode mass that is a parameter corresponding to the positive electrode capacity and a negative electrode mass that is a parameter corresponding to the negative electrode capacity. Based on the positive electrode capacity and the type of material forming the positive electrode, the positive electrode mass can be calculated by a well-known method. Similarly, based on the negative electrode capacity and the type of material forming the negative electrode, the negative electrode mass can be calculated by a well-known method. Moreover, the internal state $\theta$ may include the shift of operation window (SOW) that is a shift between the initial charge amount of the positive electrode and the initial charge amount of the negative electrode. Moreover, the internal state $\theta$ may include a parameter associated with the internal resistance of the battery cell 22 and include a parameter associated with the resistance of the positive electrode, a parameter associated with the resistance of the negative electrode, and the like.

Herein, the full charge capacity and SOC (state of charge) of each of the assembled battery 20 and the battery cells 22 are defined by an open circuit voltage (OCV).

In detail, OCV at a certain $SOC_x$ of the i-th battery cell 22 in the serially-connected n battery cells 22 included in the assembled battery 20 is set as $OCV_i(x)$. Moreover, at this time, the charge/discharge amount that satisfies Expressions (3) and (4) and is required from SOC 0% to 100% is set as a full charge capacity FCCi of the battery cell 22.

$$OCV_i(0) = V_l \qquad \cdots (3)$$

$$OCV_i(1) = V_h \qquad \cdots (4)$$

"$V_l$" in Expression (3) indicates the lower limit voltage of the battery cell 22. "$V_h$" in Expression (4) indicates the upper limit voltage of the battery cell 22.

Assuming that the SOC of the i-th battery cell 22 in SOC 0% of the assembled battery 20 is $x_i$, OCV when the SOC of the assembled battery 20 is $x_p$ is expressed by Expression (5).

$$OCV_p(x_p) = \sum_{i=1}^{n} OCV_i\left(x_i + x_p \frac{FCC_p}{FCC_i}\right) \qquad \cdots (5)$$

"$FCC_P$" in Expression (5) indicates the full charge capacity of the assembled battery 20. "$FCC_i$" indicates the full charge capacity of the battery cell 22.

By using the lower limit voltage $V_{lp}$ and the upper limit voltage $V_{hP}$ of the assembled battery 20, the full charge capacity of the assembled battery 20 is expressed by the charge/discharge amount that satisfies Expressions (6) and (7) and is required from SOC 0% to 100%.

$$OCV_p(0) = \max\left(V_{lp}, \min_{x_i \geq 0}\left(\sum_{i=1}^{n} OCV_i(x_i)\right)\right) \qquad \cdots (6)$$

$$OCV_p(1) = \min\left(V_{hp}, \max_{x_i + \frac{Q}{FCC_i} \leq 1}\left(\sum_{i=1}^{n} OCV_i\left(x_i + \frac{Q}{FCC_i}\right)\right)\right) \qquad \cdots (7)$$

Herein, the lower limit voltage of the assembled battery 20 is defined as SOC 0% when each of the battery cells 22 included in the assembled battery 20 does not reach the lower limit voltage of the battery cell 22, and when the SOC of the battery cell 22 reaches 0% (i.e., lower limit voltage) before that, the SOC of the assembled battery 20 is defined as 0% at that time point.

Similarly, the upper limit voltage of the assembled battery 20 is defined as SOC 100% when each of the battery cells 22 included in the assembled battery 20 does not reach the upper limit voltage of the battery cell 22, and when the SOC of the battery cell 22 reaches 100% before that, the SOC of the assembled battery 20 is defined as 100% at that time point.

If the full charge capacity of each of the battery cells 22 included in the assembled battery 20 and the full charge capacity of the assembled battery 20 when the SOC of the assembled battery 20 is 0% are known by Expression (5), any SOC of the assembled battery 20 can be calculated.

It is assumed that the capacity calculating module 18A calculates the internal state $\theta i$ of the i-th battery cell 22 at a certain time point by the above calculation.

In this case, an estimated value of the OCV for a certain charge amount Q is expressed by Expression (8) by omitting an overvoltage part of Expression (1).

$$\widehat{OCV}(Q, \theta) = f_c\left(\frac{Q}{M_c} + q_{0c}\right) - f_a\left(\frac{Q}{M_a} + q_{0a}\right). \qquad \cdots (8)$$

Then, based on Expressions (3) and (4), the capacity calculating module 18A calculates an estimated full charge capacity that is the cell capacity of the i-th battery cell 22 by Expression (9).

$$\widehat{FCC}_i = Q_{hi} - Q_{li} \qquad \cdots (9)$$

$\widehat{FCC}_i$ : Cell capacity of battery cell

Moreover, the OCV of the i-th battery cell 22 is expressed by Expressions (10) and (11).

$$\widehat{OCV}(Q_{li}, \theta_i) = V_l \qquad \cdots (10)$$

$$\widehat{OCV}(Q_{hi}, \theta_i) = V_h \qquad \cdots (11)$$

Similarly, the capacity calculating module 18A may calculate the cell capacity of each of the plurality of battery cells 22 included in the assembled battery 20.

Then, by using the cell capacity of each the battery cell 22, the capacity calculating module 18A calculates an assembled battery capacity of the assembled battery 20.

In detail, first, the capacity calculating module 18A calculates the SOC of each of the battery cells 22 included in the assembled battery 20 when the SOC of the assembled battery 20 is 0%.

$$\sum_{i=1}^{n} \widehat{OCV}(Q_{lp}, \theta_i) = V_{lp} \qquad \cdots (12)$$

The capacity calculating module 18A calculates a charge amount $Q_{lp}$ that satisfies Expression (12), and Expression (13) is defined based on Expression (6).

$$Q_l = \max(Q_{lp}, Q_{l1}, Q_{l2}, \ldots, Q_{ln}) \qquad \cdots (13)$$

By doing so, $SOC_{xi}$ of each the battery cell 22 when the SOC of the assembled battery 20 is 0% is expressed by Expression (14).

$$x_i = \frac{Q_l - Q_{li}}{\widehat{FCC}_i} \qquad \cdots (14)$$

For this reason, by Expression (14), the capacity calculating module 18A calculates the $SOC_{xi}$ of each the battery cell 22 when the SOC of the assembled battery 20 is 0%.

Similarly, the capacity calculating module 18A calculates the SOC of each of the battery cells 22 included in the assembled battery 20 when the SOC of the assembled battery 20 is 100%.

$$\sum_{i=1}^{n} \widehat{OCV}\left(Q_{h\,p}, \theta_i\right) = V_{hp} \qquad \cdots (15)$$

The capacity calculating module 18A calculates a charge amount $Q_{hP}$ that satisfies Expression (15), and Expression (16) is defined based on Expression (7).

$$Q_h = \min(Q_{hp}, Q_{h1}, Q_{h2}, \ldots, Q_{hn}) \qquad \cdots (16)$$

By doing so, $SOC_{yi}$ of each the battery cell 22 when the SOC of the assembled battery 20 is 100% is expressed by Expression (17).

$$y_i = \frac{Q_h - Q_{li}}{\widehat{FCC_i}} \qquad \cdots (17)$$

For this reason, by Expression (17), the capacity calculating module 18A calculates the $SOC_{yi}$ of each the battery cell 22 when the SOC of the assembled battery 20 is 100%.

Then, the capacity calculating module 18A calculates the assembled battery capacity of the assembled battery 20 by Expression (18).

$$\widehat{FCC_p} = Q_h - Q_l \qquad \cdots (18)$$

$\widehat{FCC_p}$ : Assembled battery capacity of assembled battery

By the above calculation, the capacity calculating module 18A calculates the cell capacity of each of the plurality of battery cells 22 included in the assembled battery 20 and the assembled battery capacity of the assembled battery 20.

Note that the capacity calculating module 18A may calculate the assembled battery capacity of the assembled battery 20 by using the voltages of some of the battery cells 22 included in the assembled battery 20 instead of all the battery cells 22 included in the assembled battery 20.

In this case, for example, by using an average voltage obtained by dividing the maximum voltage, the minimum voltage, and the voltage of the assembled battery 20 among the voltages of all the battery cells 22 included in the assembled battery 20 by the number of the battery cells 22 included in the assembled battery 20, the capacity calculating module 18A may calculate the assembled battery capacity of the assembled battery 20 by the above calculation.

Next, the index calculating module 18B will be described.

The index calculating module 18B calculates a ratio between the assembled battery capacity of the assembled battery 20 and the cell capacity of the specific battery cell 22 (hereinafter, referred to as specific battery cell) of the plurality of battery cells 22 included in the assembled battery 20, as an index indicating a degree of collapse of a cell balance of the assembled battery 20. The specific battery cell may be an arbitrary one battery cell of the plurality of battery cells 22 included in the assembled battery 20.

For example, the index calculating module 18B calculates SOB (state of cell-balance) expressed by Expression (19) as an index indicating the degree of collapse of the cell balance of the assembled battery 20.

SOB = Assembled battery capacity / Cell capacity of Specific battery cell (19)

The SOB is an index indicating the degree of collapse of the cell balance according to the present arrangement.

In other words, the index calculating module 18B calculates, as the SOB, a ratio of the assembled battery capacity to the cell capacity of the specific battery cell.

The cell capacity and the assembled battery capacity are assumed as a capacity having a unit such as Ah as calculated by the current integration. In the case of a unit of an electric energy (Wh), the assembled battery capacity can be substituted by an average value etc. of the cell capacities of the battery cells 22.

Furthermore, it is preferable that the index calculating module 18B calculates the SOB expressed by Expression (20) as the index indicating the degree of collapse of the cell balance of the assembled battery 20. SOB = Assembled battery capacity / Minimum cell capacity of Battery cells 22 constituting Assembled battery 20 (20)

In other words, it is preferable that the index calculating module 18B calculates a ratio of the assembled battery capacity to the cell capacity of the specific battery cell, which is the minimum cell capacity, among the plurality of battery cells 22 included in the assembled battery 20, as the index indicating the degree of collapse of the cell balance of the assembled battery 20.

When a circuit that circulates electric charges between the serially-connected battery cells 22 constituting the assembled battery 20 is not configured, an amount of current flowing in each of the battery cells 22 is constant in all the battery cells 22. For this reason, the capacity of the assembled battery 20 is not larger than that of the battery cell 22 with the lowest capacity.

Therefore, when the cell balance of the assembled battery 20 is maintained such that the charge amount between the battery cells 22 at a certain voltage is uniform, SOB is 1.

Herein, although there is a large variation in capacity of the plurality of battery cells 22 included in the assembled battery 20, the SOCs of the battery cells 22 may be identical when the SOC of the assembled battery 20 is the state of 100%. In this case, the SOCs of the battery cells 22 on the SOC 0% side of the assembled battery 20 have a state of variation. Therefore, in this case, the conventional technology cannot appropriately represent the degree of collapse of the cell balance.

On the other hand, in the index SOB indicating the degree of collapse of the cell balance used by the index calculating module 18B according to the present arrangement, SOB < 1 when the cell balance is collapsed. In detail, when the SOB is expressed by Expression (20), the SOB is expressed by a value within a range not less than 0 indicating the highest degree of collapse and not more than 1 indicating the lowest degree of collapse.

For example, it is assumed that the assembled battery 20 in which the ten battery cells 22 are serially connected has the same cell capacity in all the battery cells but the SOCs of the adjacent battery cells 22 in series are shifted by 1% in the same direction. In this case, the assembled battery capacity of the assembled battery 20 is 91% of the cell capacity of the battery cell 22 to be SOB = 0.91.

Because all the cell capacities are the same, the assembled battery capacity is substantially the same as the cell capacity if the cell balance is not collapsed. However, in this case, because the cell balance is collapsed, it can be checked by an index that the assembled battery capacity decreases.

Explanations will be performed with specific examples.

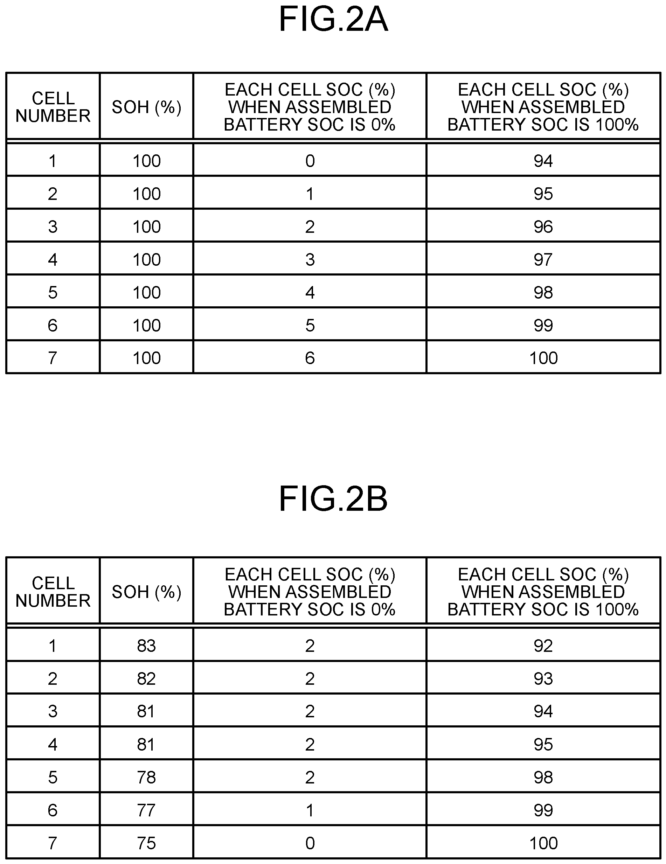

Fig. 2A is a diagram illustrating an example of a state of the assembled battery 20 in an initial state. Fig. 2B is a diagram illustrating an example of a state of the assembled battery 20 where a cycle test is executed on the assembled battery 20 in the state of Fig. 2A and at least some of the battery cells 22 are deteriorated.

Figs. 2A and 2B illustrate the SOH of the assembled battery 20 in which the seven battery cells 22 are serially connected, the SOC of each the battery cell 22 when the SOC of the assembled battery 20 is 0%, and the SOC of each the battery cell 22 when the SOC of the assembled battery 20 is 100%.

Moreover, Fig. 2A illustrates, as an example, the assembled battery 20 in which the SOH of the assembled battery 20 is 100% and all the cell capacities are the same in the initial state but the SOCs of the adjacent battery cells 22 in series are shifted by 1% in the same direction.

When the assembled battery 20 is in the state illustrated in Fig. 2A, the value of the index SOB indicating the degree of collapse of the cell balance calculated by the above calculation is 0.94.

When the assembled battery 20 is in the state illustrated in Fig. 2B, the battery cell 22 of the cell number 7 deteriorates greatly, and the expression "Cell capacity of battery cell 22 of cell number 7= Assembled battery capacity" is satisfied. For this reason, the value of the index SOB indicating the degree of collapse of the cell balance calculated by the above calculation is 1.

In the case of the state illustrated in Fig. 2B, because the capacity of the battery cell 22 of the cell number 7 deteriorates greatly and the decrease in the cell capacity of the battery cell 22 of the cell number 7 becomes greater than a shift amount between the battery cells 22, it may be said that the state where the cell balance is collapsed has been canceled. In the case of the assembled battery 20 in the state illustrated in Fig. 2B, the assembled battery capacity does not become greater than the cell capacity of the battery cell 22 of the cell number 7 even if the cell balance is adjusted by the passive cell balance IC 30.

For this reason, according to the present arrangement, it is possible to provide the index SOB that appropriately indicates the degree of collapse of the cell balance of the assembled battery 20.

As described above, note that the capacity calculating module 18A may calculate the assembled battery capacity of the assembled battery 20 by the above calculation, for example, by using an average voltage obtained by dividing the maximum voltage, the minimum voltage, and the voltage of the assembled battery 20, among the voltages of all the battery cells 22 included in the assembled battery 20, by the number of the battery cells 22 included in the assembled battery 20. In this case, the index calculating module 18B can represent the assembled battery 20 with three types of voltages to calculate the index SOB. For this reason, in this case, the processor 18 can calculate the degree of collapse of the cell balance of the assembled battery 20 with low load by using less data.

Returning to Fig. 1, the explanation is continued.

The output control module 18C outputs the index SOB calculated by the index calculating module 18B. For example, the output control module 18C causes the UI unit 14 to display the value of the index SOB calculated by the index calculating module 18B. Moreover, the output control module 18C may transmit the value of the index SOB calculated by the index calculating module 18B to an external information processing device via the communication unit 12.

Moreover, the output control module 18C may transmit the charging history recorded every hour and the value of the index SOB calculated based on the charging history to the external information processing device.

In the information processing system 1 etc. in which the number of the battery cells 22 in series in the assembled battery 20 is large and a plurality of the assembled batteries 20 are further connected in parallel, recording or transmission to the external information processing device of all the voltages of the battery cells 22 may have limitation of a recorded data amount or communication limitation. In this case, the output control module 18C may extract the charging history of some of the battery cells 22 included in the assembled battery 20, and record the charging history in the memory 16 or transmit the charging history to the external information processing device.

As described above, the capacity calculating module 18A may calculate the assembled battery capacity of the assembled battery 20 by the above calculation, for example, by using the average voltage obtained by dividing the maximum voltage, the minimum voltage, and the voltage of the assembled battery 20, among the voltages of all the battery cells 22 included in the assembled battery 20, by the number of the battery cells 22 included in the assembled battery 20. In this case, for each detection time of the voltage of the assembled battery 20 and the voltages of the battery cells 22 included in the assembled battery 20, the output control module 18C may specify at least one of the maximum voltage, the minimum voltage, the voltage of the assembled battery 20, and the average voltage of the voltages of the battery cells 22 included in the assembled battery 20, and record these voltages in association with detection times in the memory 16 as the charging history and transmit them to the external information processing device.

When the value of the index SOB calculated by the index calculating module 18B is less than a predetermined value, the cell balance control module 18D performs adjustment so that the cell balance of the assembled battery 20 becomes uniform. The predetermined value may be previously determined. The predetermined value is 1, for example, but may be a value less than 1. When the predetermined value is 1 in the present arrangement and the value of the index SOB calculated by the index calculating module 18B is less than 1, a configuration of performing adjustment so that the cell balance of the assembled battery 20 becomes uniform will be explained as an example.

In detail, the cell balance control module 18D controls the cell balance IC 30 so that the cell balance of the assembled battery 20 becomes uniform. In a well-known method, the cell balance IC 30 may align the voltages of the plurality of battery cells 22 included in the assembled battery 20 to the same voltage, and perform the well-known control of equalizing variation in the cell capacity between the battery cells 22.

Next, an example of a flow of information processing that is executed by the processor 18 of the information processing device 10 will be described.

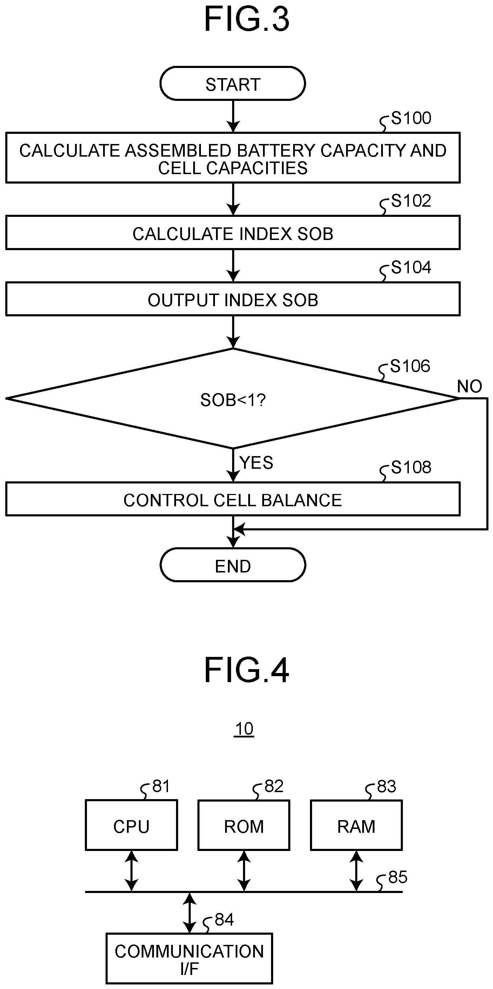

Fig. 3 is a flowchart illustrating an example of a flow of information processing that is executed by the processor 18.

The capacity calculating module 18A calculates the assembled battery capacity of the assembled battery 20 and the cell capacities of the battery cells 22 included in the assembled battery 20 (Step S100). Based on the voltage and current of the assembled battery 20, the voltage and current of at least some of the battery cells 22 included in the assembled battery 20, and the internal state calculated by the regression calculation from a relationship between the charge amount and voltage of active material of the battery cell 22, the capacity calculating module 18A calculates the cell capacities and the assembled battery capacity.

The index calculating module 18B calculates the assembled battery capacity of the assembled battery 20 relative to the cell capacity of the specific battery cell in the battery cells 22 calculated in Step S100 as the index SOB indicating the degree of collapse of the cell balance (Step S102). Herein, a case where the index calculating module 18B calculates the index SOB expressed by Expression (20) will be described.

The output control module 18C outputs the index SOB calculated in Step S102 (Step S104).

The cell balance control module 18D determines whether the index SOB calculated in Step S102 is less than 1 (Step S106). When the index SOB is 1 (Step S106: No), the present routine is terminated. When the index SOB is less than 1 (Step S106: Yes), the present routine proceeds to Step S108.

In Step S108, the cell balance control module 18D controls the cell balance IC 30 so that the cell balance of the assembled battery 20 becomes uniform (Step S108). Then, the present routine is terminated.

As described above, the processor 18 of the information processing device 10 according to the present arrangement calculates the ratio between the assembled battery capacity of the assembled battery 20 in which the plurality of battery cells 22 are serially connected and the cell capacity of the specific battery cell in the plurality of battery cells 22 included in the assembled battery 20, as the index SOB indicating the degree of collapse of the cell balance of the assembled battery 20.

Herein, a lithium-ion battery that is the battery cell 22 has excellent gravimetric energy density and volumetric energy density compared with the conventional secondary battery, and is used for various electronic/electrical products. It is expected that the battery cell 22 is installed in a mobile device such as a smartphone, and further is rapidly installed in an electric vehicle, a storage battery system, etc. with the expansion of renewable energy utilization. In the electric vehicle and the storage battery system, for the purpose of the installation of a large capacity battery, higher voltage/higher efficiency, and the like, the utilization of the assembled battery 20 in which the battery cells 22 are serially connected is performed.

Because the same current flows in any of the battery cells 22 when the battery cells 22 are serially connected, the configuration of the assembled battery 20 is performed after adjusting the cells with the same cell capacity to the same SOC when assembling the assembled battery 20. Thus, because the SOCs of the battery cells 22 are identical even if the charging and discharging are performed, the assembled battery 20 can be operated in the same way as when using a single cell.

However, when repeating the charging and discharging of the assembled battery 20, the SOCs of the battery cells 22 that have been identical at the beginning are gradually shifted and eventually do not become identical. It is considered that this has two main factors.

The first factor is a difference between self-discharge rates of the battery cells 22. Even if the self-discharge rates of the battery cells 22 are slightly different, the SOCs of the battery cells 22 are shifted bit by bit due to the long-term use. The second factor is a difference between deterioration rates of the battery cells 22. It is known that the deterioration rates are greatly different depending on temperature. When configuring the large assembled battery 20 in an electric vehicle, a storage battery system, or the like, a temperature difference occurs between the battery cells 22. For that reason, deterioration rates are different in accordance with temperature, and all the battery cells 22 do not have the same cell capacity and their SOCs are shifted.

The state where the SOCs between the cells are not identical is referred to as the collapse of the cell balance.

To cancel such the collapse of the cell balance, there is known a system mounted with a cell balancer such as the cell balance IC 30. However, it is possible to match the SOCs of the battery cells 22 at a certain SOC of the assembled battery 20 (to match the voltages of the battery cells 22), but it is difficult to match the SOCs of the battery cells 22 at all the SOCs of the assembled battery 20. If there is only the difference between the self-discharge rates that is the first factor, it is possible to match the SOCs of the battery cells 22 by a cell balancer. However, all the battery cells 22 do not have the same cell capacity due to the difference between the second deterioration rates, and the reason is because the SOCs of the battery cells 22 are shifted by the difference between the cell capacities when the same current flows.

In the charging and discharging of the assembled battery 20, the upper limit voltage and the lower limit voltage of the entire of the assembled battery 20 are defined, and further the upper limit voltage and the lower limit voltage of each the battery cell 22 are defined in many cases to prevent overcharge and overdischarge of each the battery cell 22. Therefore, the assembled battery capacity of the assembled battery 20 is not determined only by the chargeable and dischargeable capacity from the upper limit voltage to the lower limit voltage of the entire of the assembled battery 20, and is determined by the cell capacities of the battery cells 22 constituting the assembled battery 20 and the degree of collapse of the cell balance (the state of the cell balance).

For this reason, in order to grasp the deteriorated state of the assembled battery 20, it is necessary to estimate the measurable assembled battery capacity of the assembled battery 20 as well as the cell capacities of the battery cells 22 constituting the assembled battery 20 and the state of the cell balance.

In the conventional technology, with respect to the assembled battery 20 of the storage battery system, there has been proposed a method of estimating a shift of the cell capacity between the battery cells 22 constituting the assembled battery 20 as the degree of collapse of the cell balance. However, this conventional method is a method indicating a difference between cell capacities (difference between SOCs) of the battery cells 22 at a certain voltage. For example, this conventional method is a method of estimating the SOCs of the battery cells 22 at the lower limit voltage (SOC 0%) of the assembled battery 20 and the SOCs of the battery cells 22 at the upper limit voltage (SOC 100%) of the assembled battery 20, as the degree of collapse of the cell balance. However, such the conventional method is also susceptible to the influence of the variation in the cell capacities (SOHs) of the battery cells 22. For this reason, when the degree of collapse of the cell balance is determined by such the conventional method, the determination result of the cell balance is different depending on which voltage and which SOC the evaluation is performed by. Moreover, in the conventional method, because the calculation of shift of the cell capacity is performed for each the battery cell 22, the number of states increases as the number of the battery cells 22 included in the assembled battery 20 increases. For this reason, in the conventional method, the degree of collapse of the cell balance of the assembled battery 20 is not appropriately expressed.

On the other hand, the processor 18 of the information processing device 10 according to the present arrangement calculates the ratio between the assembled battery capacity of the assembled battery 20 in which the plurality of battery cells 22 are serially connected and the cell capacity of the specific battery cell in the plurality of battery cells 22 included in the assembled battery 20, as the index SOB indicating the degree of collapse of the cell balance of the assembled battery 20.

For this reason, the processor 18 according to the present arrangement can provide the index SOB appropriately representing the degree of collapse of the cell balance, even if the SOCs of the battery cells 22 at SOC 100% of the assembled battery 20 are identical and the SOCs of the battery cells 22 at SOC 0% of the assembled battery 20 have the variation, although the capacities of the plurality of battery cells 22 included in the assembled battery 20 have the large variation.

Therefore, the processor 18 according to the present arrangement can provide an index appropriately indicating the degree of collapse of the cell balance of the assembled battery 20 in which the battery cells 22 are serially connected.

Next, an example of a hardware configuration of the information processing device 10 according to the above arrangement will be described.

Fig. 4 is a hardware configuration diagram illustrating an example of the information processing device 10 according to the above arrangement.

The information processing device 10 according to the above arrangement has a hardware configuration of using a normal computer that includes a CPU (central processing unit) 81, a ROM (read only memory) 82, a RAM (random access memory) 83, a communication I/F 84, and the like to be interconnected by a bus 85.

The CPU 81 is an arithmetic device that controls the information processing device 10 according to the above arrangement. The ROM 82 stores therein a program etc. that realizes various types of processes by the CPU 81. Herein, the description is performed by using the CPU, but a GPU (graphics processing unit) may be used as an arithmetic device that controls the information processing device 10. The RAM 83 stores therein data required for various types of processes by the CPU 81. The communication I/F 84 is an interface to transmit and receive data.

In the information processing device 10 according to the above arrangement, the CPU 81 reads and executes a program on the RAM 83 from the ROM 82 and thus each the function is realized on the computer.

Note that a program for executing each the process executed by the information processing device 10 according to the above arrangement may be stored in HDD (hard disk drive). Moreover, a program for executing each the process executed by the information processing device 10 according to the above arrangement may be previously incorporated into the ROM 82 and be provided.

Moreover, a program for executing each the process executed by the information processing device 10 according to the above arrangement may be stored in a computer readable storage medium such as a CD-ROM, a CD-R, a memory card, a DVD (digital versatile disk), and a flexible disk (FD) in an installable or executable format, and be provided as a computer program product. Moreover, a program for executing each the process executed by the information processing device 10 according to the above arrangement may be stored in a computer connected to a network such as the Internet and be downloaded by way of the network to be provided. Moreover, a program for executing each the process executed by the information processing device 10 according to the above arrangement may be provided or distributed by way of a network such as the Internet.

While certain arrangements have been described, these arrangements have been presented by way of example only, and are not intended to limit the scope of the inventions. Indeed, the novel arrangements described herein may be embodied in a variety of other forms; furthermore, various omissions, substitutions and changes in the form of the arrangements described herein may be made without departing from the spirit of the inventions. The accompanying claims and their equivalents are intended to cover such forms or modifications as would fall within the scope and spirit of the inventions.

Note that the present technology can also have the following configurations.

(1) An information processing device includes: a memory; and one or more processors coupled to the memory and configured to: calculate a ratio between an assembled battery capacity of an assembled battery in which a plurality of battery cells are serially connected and a cell capacity of a specific battery cell in the plurality of battery cells included in the assembled battery, as an index indicating a degree of collapse of a cell balance of the assembled battery.

(2) In the device according to (1), the one or more processors are configured to calculate a ratio of the assembled battery capacity to the cell capacity of the specific battery cell as the index.

(3) In the device according to (1) or (2), the one or more processors are configured to calculate, as the index, a ratio between the assembled battery capacity and the cell capacity of the specific battery cell with a minimum cell capacity among the plurality of battery cells included in the assembled battery.

(4) In the device according to any one of (1) to (3), the one or more processors are configured to output the index.

(5) In the device according to any one of (1) to (4), the index is expressed by a value within a range not less than 0 and not more than 1.

(6) In the device according to any one of (1) to (5), the one or more processors are configured to calculate the cell capacity and the assembled battery capacity based on a voltage and a current of the assembled battery, a voltage and a current of at least some of the battery cells included in the assembled battery, and an internal state calculated by regression calculation from a relationship between a charge amount and a voltage of active material of the battery cell.

(7) In the device according to (6), the one or more processors are configured to use, as the voltage of at least some of the battery cells included in the assembled battery, an average voltage obtained by dividing a maximum voltage, a minimum voltage, and the voltage of the assembled battery among voltages of the plurality of battery cells by a number of the battery cells included in the assembled battery.

(8) In the device according to any one of (1) to (7), the one or more processors are configured to adjust the cell balance of the assembled battery when a value of the index is less than a predetermined value.

(9) An information processing method, executed by an information processing device, includes: calculating a ratio between an assembled battery capacity of an assembled battery in which a plurality of battery cells are serially connected and a cell capacity of a specific battery cell in the plurality of battery cells included in the assembled battery, as an index indicating a degree of collapse of a cell balance of the assembled battery.

(10) A computer-readable medium includes programmed instructions, the instructions causing a computer to execute: calculating a ratio between an assembled battery capacity of an assembled battery in which a plurality of battery cells are serially connected and a cell capacity of a specific battery cell in the plurality of battery cells included in the assembled battery, as an index indicating a degree of collapse of a cell balance of the assembled battery.

(11) An information processing system includes: an assembled battery including a plurality of battery cells connected serially; and one or more processors configured to calculate a ratio between an assembled battery capacity of the assembled battery and a cell capacity of a specific battery cell in the plurality of battery cells included in the assembled battery, as an index indicating a degree of collapse of a cell balance of the assembled battery.

**Claims**

1. An information processing device (10) comprising:

   a memory (16); and
   one or more processors (18) coupled to the memory and configured to:
   calculate a ratio between an assembled battery capacity of an assembled battery (20) in which a plurality of battery cells (22) are serially connected and a cell capacity of a specific battery cell in the plurality of battery cells (22) included in the assembled battery (20), as an index indicating a degree of collapse of a cell balance of the assembled battery (20).

2. The device (10) according to claim 1, wherein the one or more processors (18) are configured to calculate a ratio of the assembled battery capacity to the cell capacity of the specific battery cell as the index.

3. The device (10) according to claim 1, wherein the one or more processors (18) are configured to calculate, as the index, a ratio between the assembled battery capacity and the cell capacity of the specific battery cell with a minimum cell capacity among the plurality of battery cells (22) included in the assembled battery (20).

4. The device (10) according to claim 1, wherein the one or more processors (18) are configured to output the index.

5. The device (10) according to claim 3, wherein the index is expressed by a value within a range not less than 0 and not more than 1.

6. The device (10) according to claim 1, wherein the one or more processors (18) are configured to calculate the cell capacity and the assembled battery capacity based on a voltage and a current of the assembled battery (20), a voltage and a current of at least some of the battery cells (22) included in the assembled battery (20), and an internal state calculated by regression calculation from a relationship between a charge amount and a voltage of active material of the battery cell.

7. The device (10) according to claim 6, wherein the one or more processors (18) are configured to use, as the voltage of at least some of the battery cells (22) included in the assembled battery (20), an average voltage obtained by dividing a maximum voltage, a minimum voltage, and the voltage of the assembled battery (20) among voltages of the plurality of battery cells (22) by a number of the battery cells (22) included in the assembled battery (20).

8. The device (10) according to claim 1, wherein the one or more processors (18) are configured to adjust the cell balance of the assembled battery (20) when a value of the index is less than a predetermined value.

9. An information processing method executed by an information processing device, the method comprising: calculating a ratio between an assembled battery capacity of an assembled battery (20) in which a plurality of battery cells (22) are serially connected and a cell capacity of a specific battery cell in the plurality of battery cells (22) included in the assembled battery (20), as an index indicating a degree of collapse of a cell balance of the assembled battery (20).

10. A computer-readable medium including programmed instructions, the instructions causing a computer to execute: calculating a ratio between an assembled battery capacity of an assembled battery (20) in which a plurality of battery cells (22) are serially connected and a cell capacity of a specific battery cell in the plurality of battery cells (22) included in the assembled battery (20), as an index indicating a degree of collapse of a cell balance of the assembled battery (20).

11. An information processing system (1) comprising:

an assembled battery (20) including a plurality of battery cells (22) connected serially; and
one or more processors (18) configured to calculate a ratio between an assembled battery capacity of the assembled battery (20) and a cell capacity of a specific battery cell in the plurality of battery cells (22) included in the assembled battery (20), as an index indicating a degree of collapse of a cell balance of the assembled battery (20).

# FIG.1

_1_

LOAD/
POWER SUPPLY `24`

VOLTAGE
DETECTOR `28`

CELL BALANCE
IC `30`

CURRENT
DETECTOR `26`

`20`
`22`
`22`
`22`
`22`

INFORMATION
PROCESSING
DEVICE `10`

PROCESSOR `18`

COMMUNICATION
UNIT `12`

UI UNIT `14`

MEMORY `16`

CAPACITY
CALCULATING MODULE `18A`

INDEX CALCULATING
MODULE `18B`

OUTPUT CONTROL
MODULE `18C`

CELL BALANCE
CONTROL MODULE `18D`

# FIG.2A

| CELL NUMBER | SOH (%) | EACH CELL SOC (%) WHEN ASSEMBLED BATTERY SOC IS 0% | EACH CELL SOC (%) WHEN ASSEMBLED BATTERY SOC IS 100% |
|---|---|---|---|
| 1 | 100 | 0 | 94 |
| 2 | 100 | 1 | 95 |
| 3 | 100 | 2 | 96 |
| 4 | 100 | 3 | 97 |
| 5 | 100 | 4 | 98 |
| 6 | 100 | 5 | 99 |
| 7 | 100 | 6 | 100 |

# FIG.2B

| CELL NUMBER | SOH (%) | EACH CELL SOC (%) WHEN ASSEMBLED BATTERY SOC IS 0% | EACH CELL SOC (%) WHEN ASSEMBLED BATTERY SOC IS 100% |
|---|---|---|---|
| 1 | 83 | 2 | 92 |
| 2 | 82 | 2 | 93 |
| 3 | 81 | 2 | 94 |
| 4 | 81 | 2 | 95 |
| 5 | 78 | 2 | 98 |
| 6 | 77 | 1 | 99 |
| 7 | 75 | 0 | 100 |

# FIG.3

```
        START
          │
          ▼                                    S100
┌──────────────────────────────────────────┐
│ CALCULATE ASSEMBLED BATTERY CAPACITY AND  │
│            CELL CAPACITIES                 │
└──────────────────────────────────────────┘
          │
          ▼                                    S102
┌──────────────────────────────────────────┐
│           CALCULATE INDEX SOB             │
└──────────────────────────────────────────┘
          │
          ▼                                    S104
┌──────────────────────────────────────────┐
│            OUTPUT INDEX SOB               │
└──────────────────────────────────────────┘
          │
          ▼                                    S106
        ╱──────────────────────────────╲      NO
       ╱            SOB<1?               ╲────────┐
        ╲──────────────────────────────╱         │
          │ YES                                   │
          ▼                            S108       │
┌──────────────────────────────────────────┐     │
│           CONTROL CELL BALANCE            │     │
└──────────────────────────────────────────┘     │
          │◄───────────────────────────────────── ┘
          ▼
         END
```

# FIG.4

10

```
    ┌─────────┐    ┌─────────┐    ┌─────────┐
    │ 81      │    │ 82      │    │ 83      │
    │  CPU    │    │  ROM    │    │  RAM    │
    └────┬────┘    └────┬────┘    └────┬────┘
         ▲              ▲              ▲   85
         │              │              │
    ─────┴──────────────┴──────────────┴──────
              ▲
              │  84
         ┌────┴─────────┐
         │ COMMUNICATION│
         │     I/F      │
         └──────────────┘
```

Europäisches
Patentamt

European
Patent Office

Office européen
des brevets

# EUROPEAN SEARCH REPORT

**Application Number**

EP 24 17 6878

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 160 236 A1 (YOKOGAWA ELECTRIC CORP [JP]) 5 April 2023 (2023-04-05) <br> * paragraphs [0012] - [0015] * <br> * paragraph [0017] - paragraph [0021] * <br> * paragraph [0025] - paragraph [0042] * <br> * paragraph [0050] - paragraph [0052] * <br> * paragraph [0056] - paragraph [0067] * <br> * claims 1-5; figures 3-7 * | 1-11 | INV. <br> G01R31/396 |
| A | WO 2023/153602 A1 (MINTECH CO LTD [KR]) 17 August 2023 (2023-08-17) <br> * Fig.3 and its description * | 1-11 | |
| A | US 2022/146585 A1 (HONG YOUNG JIN [KR] ET AL) 12 May 2022 (2022-05-12) <br> * paragraphs [0005] - [0009], [0042] - [0092] * <br> * figures 1-3 * | 1-11 | |
| | | | **TECHNICAL FIELDS SEARCHED (IPC)** <br><br> G01R |

The present search report has been drawn up for all claims

| Place of search | Date of completion of the search | Examiner |
|---|---|---|
| Munich | 19 October 2024 | Stussi, Elisa |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 17 6878

This annex lists the patent family members relating to the patent documents cited in the above-mentioned European search report.
The members are as contained in the European Patent Office EDP file on
The European Patent Office is in no way liable for these particulars which are merely given for the purpose of information.

19-10-2024

| Patent document cited in search report | | Publication date | Patent family member(s) | | Publication date |
|---|---|---|---|---|---|
| EP 4160236 | A1 | 05-04-2023 | CN | 115911603 A | 04-04-2023 |
| | | | EP | 4160236 A1 | 05-04-2023 |
| | | | JP | 7372295 B2 | 31-10-2023 |
| | | | JP | 2023051291 A | 11-04-2023 |
| | | | US | 2023098799 A1 | 30-03-2023 |
| WO 2023153602 | A1 | 17-08-2023 | CN | 118647883 A | 13-09-2024 |
| | | | KR | 20230119756 A | 16-08-2023 |
| | | | WO | 2023153602 A1 | 17-08-2023 |
| US 2022146585 | A1 | 12-05-2022 | CN | 113678009 A | 19-11-2021 |
| | | | EP | 3916411 A1 | 01-12-2021 |
| | | | ES | 2969305 T3 | 17-05-2024 |
| | | | JP | 7232548 B2 | 03-03-2023 |
| | | | JP | 2022522733 A | 20-04-2022 |
| | | | US | 2022146585 A1 | 12-05-2022 |
| | | | WO | 2021107220 A1 | 03-06-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012251806 A
- JP 2018077259 A
- JP 2015111086 A